# EUROPEAN PATENT APPLICATION

(11) **EP 3 865 694 A1**
(43) Date of publication of application: **18.08.2021**
(21) Application number: 21154994.4
(22) Date of filing: 03.02.2021
(51) Int. Cl.: F02C 7/12, F01D 25/12, F02B 29/04, H02K 9/19, H05K 7/20, F02C 7/18

(54) **THERMAL MANAGEMENT SYSTEM AND METHOD OF USE**

(30) Priority: 12.02.2020 US 202016788680
(71) Applicant: Hamilton Sundstrand Corporation, Charlotte, NC 28217-4578 (US)
(72) Inventor: PAL, Debabrata, Hoffman Estates, IL Illinois 60195 (US); UTECHT, Tom A., Cherry Valley, IL Illinois 61016 (US); LEGROS, Craig R., Rockford, IL Illinois 61109 (US)
(74) Representative: Dehns

(57) **Abstract**

An thermal management system (110) including, a body (202) having a coolant passage (204) in thermal communication with an electronic device (110), a first heat exchanger (116) fluidically connected to the coolant passage configured to receive the coolant from the coolant passage, a second heat exchanger (120) fluidically connected to the first heat exchanger, and a generator (122) fluidically connected to the second heat exchanger.

## Description

### Background

### Technological Field

The present disclosure relates to electronics thermal management, and more particularly to thermal management of a device during startup.

### Description of Related Art

A variety of devices are known for providing a cooling solution for power electronics. Power electronics devices are usually mounted on a heat spreader or a cold plate or to a heat sink in order to cool them during operation. Typical packaging configurations usually result in bulky designs, which has a relatively high volume, especially for air cooled cases. The aerospace industry demands lightweight and high compactness packaging solutions while also significantly increasing power level requirements. Further, typical configurations require bypass air to cool electronics. However, during startup or other motionless activities, no bypass air is available to provide cooling to electronics.

The conventional methods and systems have generally been considered satisfactory for their intended purpose, but are not appropriate any more when due to an increase in output powers of power electronics devices and volume and/or weight constrains remaining the same.. However, there is still a need in the art for a thermal management system that is able to provide an appropriate amount of cooling prior during startup. The present disclosure may provide a solution for at least one of these remaining challenges.

### Summary of the Invention

An aircraft thermal management system includes a body having a coolant passage defined by at least a first wall and a second wall, wherein the first wall being in thermal communication with an electronic device, a first heat exchanger fluidically connected to the coolant passage configured to receive the coolant from the coolant passage, a second heat exchanger fluidically connected to the first heat exchanger, and a generator fluidically connected to the second heat exchanger. The electronic device can be a bi-directional rectifier.

The first heat exchanger can be an air-coolant heat exchanger and a fuel-coolant heat exchanger. The second heat exchanger can be an air-coolant heat exchanger and a fuel-coolant heat exchanger. A first pump can be located downstream of the coolant passage configured to drive fuel out of the coolant passage and a second pump can be located downstream of the generator configured to drive fuel from the generator. The coolant can be an oil coolant. The first heat exchangers can be located within a fan casing of an aircraft engine and be coupled to a nacelle of an aircraft engine.

A method of managing heat of an electronic device on an aircraft engine includes pumping a coolant through a passage of a body coupled to an electronic device, transferring heat from the electronic to device to the coolant within the passage of the body prior to aircraft engine start up, transferring heat from the coolant to a first fluid within a first heat exchanger, producing bypass airflow, and transferring heat from the coolant to a second fluid within the first heat exchanger after engine startup. The bypass air can be fan bypass air. No bypass flow is available during aircraft engine startup, and aircraft engine startup is a short-term thermal transient operation. The first fluid can be fuel and the second fluid can be air.

These and other features of the systems and methods of the subject disclosure will become more readily apparent to those skilled in the art from the following detailed description of the preferred embodiments taken in conjunction with the drawings.

### Brief Description of the Drawings

So that those skilled in the art to which the subject invention appertains will readily understand how to make and use the devices and methods of the subject invention without undue experimentation, preferred embodiments thereof will be described in detail herein below, by way of example only and with reference to certain figures, wherein:
Fig. 1 is a schematic view of a thermal management system for an electronic device;
Fig. 2 is a schematic view of the electronics module of Fig. 1, showing the arrangement of the coolant passage; and
Fig. 3 is a schematic view of the thermal management system of Fig. 1 in situ.

### Detailed Description

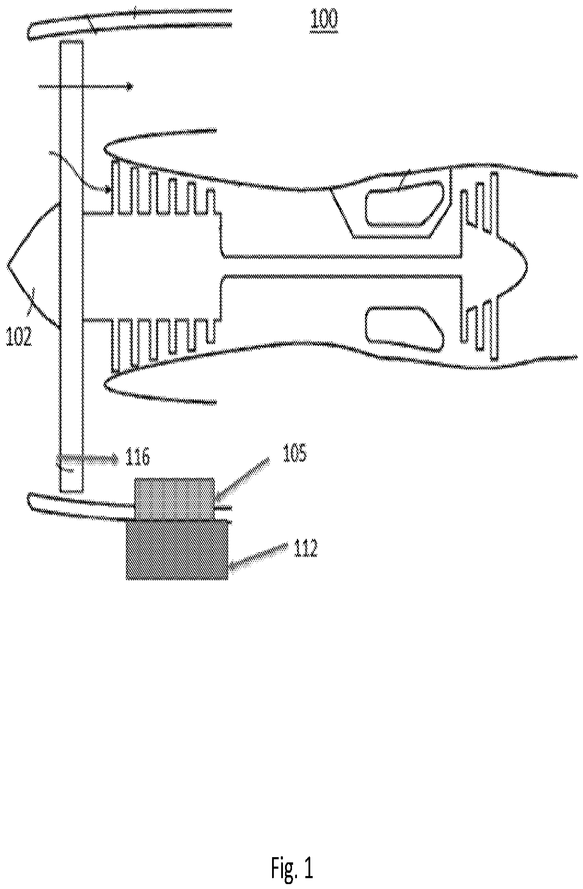

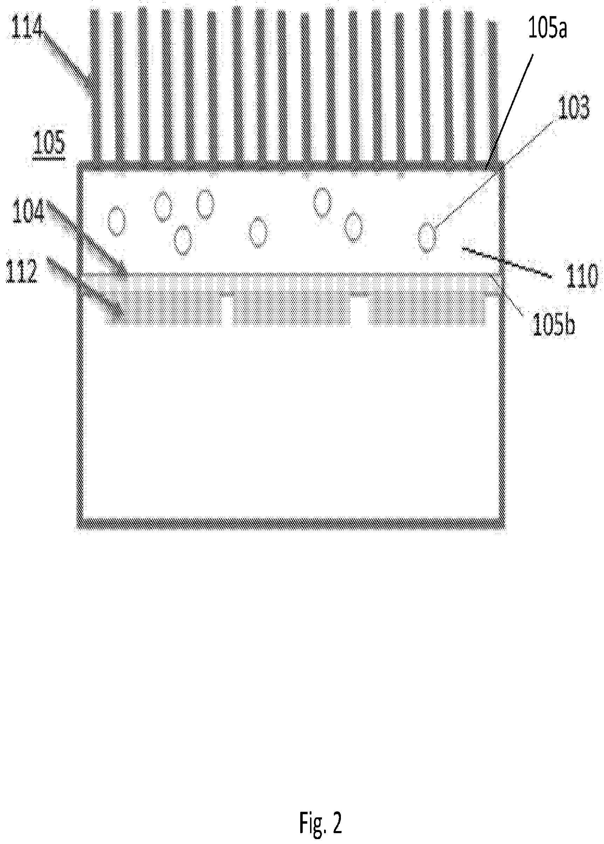

Reference will now be made to the drawings wherein like reference numerals identify similar structural features or aspects of the subject invention. For purposes of explanation and illustration, and not limitation, a partial view of an exemplary embodiment of a thermal management body in accordance with the invention is shown in Fig. 1 and is designated generally by reference character 100. Other embodiments of the thermal management body in accordance with the invention, or aspects thereof, are provided in Figs. 2 and 3, as will be described. The methods and systems of the invention can be used to provide a more compact, lighter and more efficient electronics thermal management device which provides a passive, thin and low weight compact high performance cold plate based solution for bi directional rectifier cooling. Bi-directional rectifier converts DC to 3 phase AC power and supplies to the engine starter/generator.

Fig. 1 shows an aircraft thermal management 100 system an electronic device 110 such as bidirectional active rectifier. A pump 114 is placed to circulate coolant through system 100, and direct it to the first heat exchanger 116. The first heat exchanger 116 is used to cool the coolant. During ground operation and main engine start, fuel is used to cool the coolant. As the aircraft begins to move and air starts to circulate through the enging fan and nacelle, the first heat exchanger 116 is switched to using air flow to cool the coolant passing through the first heat exchanger 116. As shown in Fig. 3, it is also considered that a nacelle scoop 300 can be opened during flight to use cold air is used to cool the coolant. After the ram air flow develops following take off, a RAM air flow scoop valve will open and will provide cooling to the heat exchanger 116. Also seen in Fig. 1, a second heat exchanger 120 is fluidically connected to the first heat exchanger 116, and a generator 122 is fluidically connected to the second heat exchanger 120. The system 100 also includes a second pump 124 independent of the first pump 114, connected to the generator 122 and the second heat exchanger 120. The generator 122 received coolant to cool both the stator and rotor.

Fig. 2 shows a body 202 having a coolant passage 204 defined by at least a first wall 206 and a second wall 208. The first wall 206 is in thermal communication with the electronic device 110. The electronic device 110 is in contact with the first wall 206 by a liquid cooled cold plate 112. The device 110 can include a series of fins protruding into the coolant passage in order to improve the heat transfer. The device 110 can include a series of power modules 130 which also contact the first wall 206 in order to be cooled more efficiently.

This method and system provides a thinner and lower weight compact high performance solution for cooling an electric member. Using this cooling approach, the bi-directional rectifier is be able to perform main engine start on ground when main fan air flow is not available. Also using RAM air flow to cool the first heat exchanger 116 provide advantage in flight; fuel is not be used for cooling during flight, thus eliminating safety concerns in using fuel for heat transfer use. In addition, using oil to cool the active rectifier will eliminate direct fuel cooling risks.

The methods and systems of the present disclosure, as described above and shown in the drawings, provide for electronics thermal management system with superior properties including increased reliability and reduced size and weight. While the apparatus and methods of the subject disclosure have been shown and described with reference to embodiments, those skilled in the art will readily appreciate that changes and/or modifications may be made thereto without departing from the scope of the subject disclosure as defined by the claims.

## Claims

1. An aircraft engine thermal management system (100) comprising:
a body (202) having a coolant passage (204) in thermal communication with an electronic device (110);
a first heat exchanger (116) fluidically connected to the coolant passage configured to receive the coolant from the coolant passage;
a second heat exchanger (120) fluidically connected to the first heat exchanger; and
a generator (122) fluidically connected to the second heat exchanger.

2. The system of claim 1, wherein the electronic device includes a bi-directional rectifier.

3. The system of claim 1 or 2, wherein the first heat exchanger is an air-coolant heat exchanger and a fuel-coolant heat exchanger.

4. The system of any preceding claim, wherein the second heat exchanger is an air-coolant heat exchanger and a fuel-coolant heat exchanger.

5. The system of any preceding claim, wherein a first pump (114) is located downstream of the coolant passage configured to drive fuel out of the coolant passage.

6. The system of claim 5, wherein a second pump (124) is located downstream of the generator configured to drive fuel from the generator.

7. The system of any preceding claim, wherein the coolant is an oil coolant.

8. The system of any preceding claim, wherein the first heat exchanger is located within a fan casing of an aircraft engine.

9. The system of any preceding claim, wherein the first heat exchanger is coupled to a nacelle of an aircraft engine.

10. A method of managing heat of an electronic device on an aircraft engine comprising:
pumping a coolant through a passage (204) of a body (202) coupled to an electronic device (110);
transferring heat from the electronic to device to the coolant within the passage of the body prior to aircraft engine start up;
transferring heat from the coolant to a first fluid within a first heat exchanger (116);
producing bypass airflow; and
transferring heat from the coolant to a second fluid within the first heat exchanger after engine startup.

11. The method of claim 10, wherein the bypass air is fan bypass air.

12. The method of claim 11, wherein there is no bypass flow during aircraft engine startup.

13. The method of claim 10, 11 or 12, wherein aircraft engine startup is a short-term thermal transient operation.

14. The method of claim 10, 11, 12 or 13, wherein the first fluid is fuel.

15. The method of any of claims 10 to 14, wherein the second fluid is air.
